Europäisches Patentamt

European Patent Office

Office européen des brevets

(19)

(11) **EP 1 028 505 B1**

(12) **EUROPEAN PATENT SPECIFICATION**

(45) Date of publication and mention
of the grant of the patent:
**22.05.2002 Bulletin 2002/21**

(51) Int Cl.⁷: **H01S 5/42**

(21) Application number: **99123311.5**

(22) Date of filing: **22.11.1999**

(54) **A vertical-cavity surface-emitting laser comprised of single laser elements arranged on a common substrate**

Oberflächenemittierender Laser mit vertikalem Resonator und einzelnen auf einem gemeinsamen Substrat angeordneten Laserelementen

Laser à cavité verticale à émission par la surface comprenant des éléments laser formés sur un substrat commun

(84) Designated Contracting States:
**AT BE CH CY DE DK ES FI FR GB GR IE IT LI LU MC NL PT SE**

(30) Priority: **11.02.1999 EP 99101756**

(43) Date of publication of application:
**16.08.2000 Bulletin 2000/33**

(73) Proprietor: **Avalon Photonics Ltd.**
**8048 Zürich (CH)**

(72) Inventors:
• **Kapon, Elyahou**
**1005 Lausanne (CH)**
• **Monti di Sopra, Fabrice**
**8047 Zürich (CH)**
• **Brunner, Marcel**
**8049 Zürich (CH)**

(74) Representative: **Grünecker, Kinkeldey, Stockmair & Schwanhäusser Anwaltssozietät**
**Maximilianstrasse 58**
**80538 München (DE)**

(56) References cited:
**US-A- 5 258 316**    **US-A- 5 444 731**

• **MORGAN R A: "HIGH-POWER COHERENTLY COUPLED 8X8 VERTICAL CAVITY SURFACE EMITTING LASER ARRAY" APPLIED PHYSICS LETTERS,US,AMERICAN INSTITUTE OF PHYSICS. NEW YORK, vol. 61, no. 10, 7 September 1992 (1992-09-07), pages 1160-1162, XP000296378 ISSN: 0003-6951**
• **DEPPE D G ET AL: "PHASE-COUPLED TWO-DIMENSIONAL ALXGA1-XAS-GAAS VERTICAL-CAVITY SURFACE-EMITTING LASER ARRAY" APPLIED PHYSICS LETTERS,US,AMERICAN INSTITUTE OF PHYSICS. NEW YORK, vol. 56, no. 21, 21 May 1990 (1990-05-21), pages 2089-2091, XP000149946 ISSN: 0003-6951**
• **TANG X ET AL: "OBSERVATION OF BISTABILITY IN GAAS QUANTUM-WELL VERTICAL-CAVITY SURFACE-EMITTING LASERS" IEEE JOURNAL OF QUANTUM ELECTRONICS, vol. 33, no. 6, 1 June 1997 (1997-06-01), pages 927-932, XP000700952**

EP 1 028 505 B1

**Description**

The present invention relates to a vertical-cavity surface-emitting laser (VCSEL) device comprising a plurality of VCSEL elements arranged on a common substrate, each VCSEL element comprising first mirror means having a first reflectivity and second mirror means having a second reflectivity at a predetermined wavelength for forming an optical resonator for said wavelength, and a laser active region disposed between said first and second mirror means.

Semiconductor laser devices steadily gain in importance in a plurality of industrial applications. In particular, in the fields of gas spectroscopy, coupling of laser light into optical fibers, and in communication systems where a high transmission rate is required, semiconductor laser devices with high spectral purity, i.e. with single mode output radiation in the longitudinal as well as the transverse directions, are highly desirable. Especially, vertical-cavity surface-emitting lasers (VCSEL) represent an important development, since the possibility of manufacturing a large plurality of such laser devices on a single semiconductor substrate provides laser devices with high efficiency and low power consumption in conjunction with low manufacturing costs. These laser devices inherently lase in a single longitudinal mode due to their small longitudinal extension of the laser active region (some hundreds of nanometers). When, however, a high output power from a single device is required, the lateral extension of this device has to be increased, thereby reducing the spectral purity of the laser output, since then the beam quality suffers from the competition of many transverse radiation modes. Accordingly, the highest possible single mode output power from a VCSEL is limited (currently the maximum value achieved is 4.8 mW), since the size of the VCSEL must remain small to restrict emission to a single fundamental transverse mode.

In order to achieve increased output power while maintaining a well-defined single transverse mode which is desirable for a variety of applications such as laser printing, material treatment, or optical pumping, so-called "phase coupled arrays" have been developed and investigated during the last years. In such a phase coupled array, usually the top or bottom surface of a laterally widely extending VCSEL is divided into a plurality of laser elements by means of a grid-like structure, typically formed of metal. The thickness of the grid bars separating adjacent laser elements are selected so as to allow the electric fields of adjacent elements to couple to each other. Since, in general, top and bottom distributed Bragg reflectors as well as the laser active region are provided common to all single laser elements, and a current is supplied to the common active region by means of the conductive grid bars, the laser elements are no longer individually addressable. Accordingly, the phase coupled array can also be considered a laterally large VCSEL device emitting in a coherent supermode, wherein the nodes of the electric field are defined by the grid structure on the top or bottom surface of the VCSEL.

In the early 1990's, phase coupled arrays were demonstrated for the first time and, in recent developments, have shown very promising behavior in pulsed operation with more than 500 mW of a single mode peak output power in, for example, an 8 x 8 array, as disclosed in "Applied Physical Letters" Vol.61, 1160 (1992).

In order to provide for a phase coupled array in a VCSEL, a variety of possibilities have been practiced in the prior art.

In IEEE "Journal of Quantum Electronics," Vol. 26, No.11, November 1990, a phase coupled array is described having a metal grid inside the cavity defining areas of low reflectivity. Subsequently, a dielectric mirror has been deposited after the formation of the metal grid and this dielectric and serves as the outcoupling mirror of the laser device. This fabrication technology, however, is quite complicated and the device exhibits during operation a mixture of the lowest order and several high order modes, so that this approach does not seem to be very promising.

In "Optics Letters," Vol.18, No.5, March 1, 1993, a VCSEL is disclosed having a metal grid applied to the top of a complete VCSEL structure, including two semiconductor distributed Bragg reflectors. However, the reflectivity variation induced by the metal grid alone, is too low to stabilize the highest order transverse mode for CW operation.

In "Applied Physical Letters," Vol.60, 1535, 1992, a bottom emitting VCSEL structure is described, having a semiconductor bottom mirror and a hybrid semiconductor/gold top mirror. The reflectivity of the top mirror is fine-tuned with two different metalizations, wherein highly reflective gold is evaporated on the laser elements, while less reflective TiAu or Cr/Au is used for the grid which defines the individual laser elements. Since no light can escape through the top metals, this technology is only appropriate for bottom emitters.

In "Applied Physical Letters," Vol.58, 890, 1991, a VCSEL is disclosed, wherein a grid is etched into the top distributed Bragg reflector. According to this technology, no current injection is possible and, hence, the device is merely able to be operated with optical pumping.

It is, therefore, an object of the present invention to provide a VCSEL device having a high output power with a defined single transverse radiation mode, whereby the aforementioned disadvantages of the prior art are avoided.

According to the present invention, there is provided a vertical-cavity surface-emitting laser device comprising a plurality of VCSEL elements arranged on a common substrate, each VCSEL element comprising first mirror means and second mirror means each having a predefined reflectivity at a predetermined wavelength, for forming an optical resonator for said wavelength, a laser active region disposed between said first and second mirror means, and a grid layer arranged over said first mirror means, said grid layer having a plurality of openings corresponding to the respective VCSEL elements, said VCSEL device being characterized in that it comprises a contact layer having a predetermined thickness, said contact layer being interposed between and adjacent to each of said first mirror means and said grid layer, wherein an optical thickness of said contact layer and a reflectivity and an absorption of said grid layer is selected so as to provide an effective reflectivity of each of said first mirror means depending on said grid layer and being different for areas covered by the grid and areas corresponding to said grid openings.

According to the present invention, the employment of the contact layer in combination with the structure of the grid layer, i.e. the geometric structure as well as the composition and the thickness thereof, provides simple means for a significant variation of the reflectivity of the first mirror means. Due to the varying reflectivity along the lateral dimension of the VCSEL device, the loss within the cavity varies accordingly and, hence, a single transverse radiation mode is sufficiently stabilized. Therefore, the VCSEL device of the present invention allows, contrary to the prior art devices which are described to be operated only in a pulsed mode, the operation with constant current and continuous wave (cw) thereby insuring a high continuous output power exhibiting a single transverse radiation mode.

Preferably, said first and second mirror means are provided as Bragg reflectors which are common to all of said VCSEL elements. By this measure, a high density of VCSEL elements may be provided, and, at the same time, the manufacturing process for such a device is considerably simplified. Moreover, manufacturing of such devices is compatible to standard fabrication methods such as selective oxidation, mesa etching, and proton implantation.

Advantageously, the thickness of said contact layer is adjusted such that the reflectivity of said first mirror means is reduced in regions covered by the grid, compared to regions corresponding to said grid openings. An accordingly arranged contact layer and grid layer insure that the reflectivity and, hence, the loss of the resonator in regions corresponding to the portions covered by the grid, is relatively low so that the transverse radiation mode having an intensity minimum at those portions is significantly stabilized, whereas other transverse radiation modes are remarkably suppressed.

In a preferred embodiment, the thickness of said contact layer is adjusted so as to obtain the minimum reflectivity of said regions covered by said grid layer for a given composition of the first mirror means and said grid layer.

By this measure, the lateral reflectivity contrast reaches a maximum value and, hence, the suppression of undesired transverse radiation modes is maximized.

Preferably, said grid layer comprises more than one layer, each of said layers consisting of a material having a defined index of refraction, a defined absorption coefficient and a defined thickness.

Advantageously, said regions not covered by said grid layer form radiation emission windows for a radiation of said wavelength. In this way, the radiation is output through the opening of the grid layer and the bars of the grid layer additionally serve as an optical aperture.

Preferably, an extension of each of said radiation emission windows is arranged to select substantially a fundamental transverse radiation mode of said radiation with respect to the corresponding VCSEL element. This leads to an arrangement in which the VCSEL device in its entirety emits in the highest order transverse radiation mode (supermode).

Advantageously, the absolute reflectivity of said first and second mirror means including optical characteristics of said contact layer and said grid layer is selected so as to obtain the minimum reflectivity required to generate stimulated emission. Thus, it is guaranteed that the VCSEL device emits a laser beam once a certain current is supplied to the active region.

Preferably, said grid layer comprises at least one metal layer. This allows to use the grid layer concurrently as an electrode for injecting charge carriers into the active region.

Advantageously, an additional dielectric mirror is provided on top of said first mirror means so as to further increase the overall reflectivity of the resonator.

Preferably, said first reflectivity, in the areas covered by the grid, is reduced by at least 3 percent compared to the reflectivity of said areas corresponding to the grid openings.

In a preferred embodiment, said grid layer is a raster of squares or rectangles. In such an arrangement, each pixel can naturally couple to its nearest neighbors 180° out of phase, which leads to emission in the highest order supermode of the device.

Advantageously, a bar width of said grid layer is less than 10μm and is preferably less than 5μm (typically 1 μm). An accordingly arranged bar width of said grid layer separating adjacent radiation emission windows allows the electric fields of corresponding adjacent VCSEL elements to sufficiently couple to each other so that a single transverse radiation supermode is maintained. However, with thinner bars, not only the coupling between adjacent VCSELs is stronger but the area coverage of the bars is smaller, thereby making the coupling of the light out of the device more efficient.

Preferably, a maximum dimension of each radiation emission window of each VCSEL element is in the range of 2μm to 10μm. With these dimensions, the fundamental mode of each VCSEL element is efficiently selected.

In a preferred embodiment, the grid layer is a honeycomb raster and a resistance layer is provided, formed between the first and second mirror means and having at least one region corresponding to an opening of said honeycomb raster with a high electrical resistance and said at least one high resistance region has 6 nearest-neighbor-regions having a low electrical resistance.

Since the highest order supermode requires two adjacent VCSEL elements to emit radiation with a phase difference of 180°, each VCSEL element in the center of 6 surrounding elements in the honeycomb raster does not meet this requirement. By providing said resistance layer which at least covers the area of a central element, the charge carriers flowing through the active region are forced to concentrate in the neighboring VCSEL elements having low electrical resistance. Therefore, although the net current flow remains at the same level, the charge carrier density in the active regions of the VCSEL elements neighboring said central element is increased, thereby increasing the conversion efficiency of these active regions.

Preferably, said high resistance region comprises an exposed portion where at least the overlying layers of the Bragg mirror have a vertical opening. By means of this vertical opening, the high resistance region can easily be manufactured by selective oxidation of a buried layer having a high content of aluminum.

In a further preferred embodiment, a grid matching resistance layer is provided between said one of said mirror means and said laser active region, said grid matching resistance layer having a high electrical resistance at least in regions covered by said grid layer. Since the geometric structure of the grid matching resistance layer matches the geometry of said grid layer, the charge carrier density can be increased in regions where the reflectivity is high and, thus, the optical gain is additionally improved.

In the following, the present invention shall be explained in more detail with reference to the drawings, wherein:

Figure 1 is a schematic cross-sectional view of an embodiment of the present invention;

Figure 2 is a graph showing the reflectivities of a Bragg mirror covered with a contact layer alone (solid line) and additionally with a grid layer composed of metal layers (broken line) with respect to the thickness of the contact layer;

Figures 3a to 3e schematically depict various geometric structures of the grid layer;

Figures 4a to 4c schematically depict the geometric structure of the grid layer according to a further embodiment of the present invention;

Figure 4d shows a schematic cross-sectional view of the embodiment as shown in Figure 4c; and

Figure 5 is a schematic cross-sectional view of a further embodiment of the present invention which is similar to the device as shown in Figure 1.

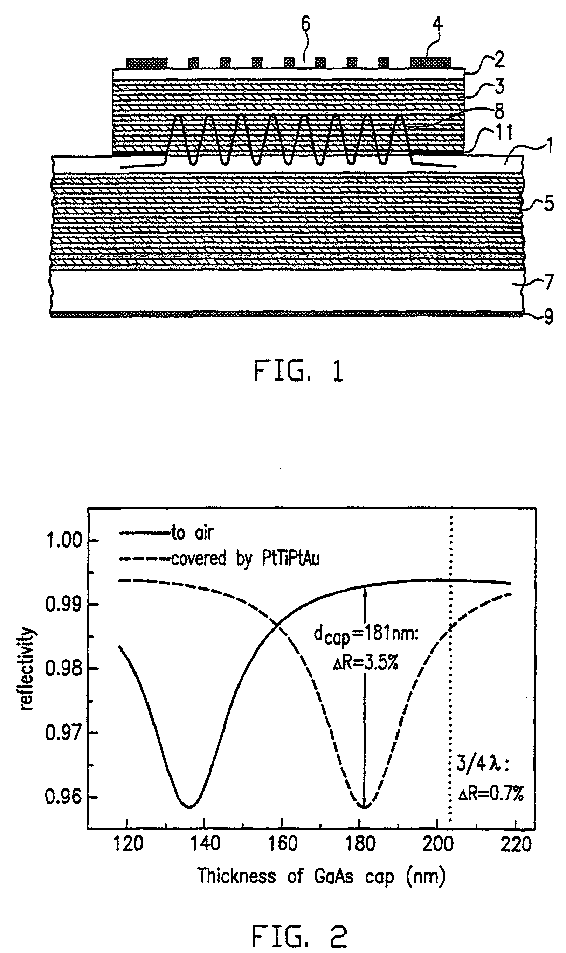

Figure 1 shows a schematic cross-sectional view of an embodiment of a VCSEL device according to the present invention. In Figure 1, the bottom surface of a substrate layer 7 is covered by a metal layer 9. Over the substrate layer 7 a laser active region 1 is formed. Active region 1 is disposed between second mirror means 5 formed over substrate layer 7, and first mirror means 3. First and second mirror means 3, 5 are composed of distinct layers having alternatingly a high index of refraction and a low index of refraction. In this example, alternating layers of GaAs having a thickness of 68nm and $Al_{0.9}Ga_{0.1}As$ having a thickness of 80nm, are employed to form a resonator for an output wavelength of 960nm, however, other material compositions are suitable as well. On top of first mirror means 3 a contact layer 2 is formed. On the contact layer 2, a grid layer 4 is formed, having a plurality of openings 6. The thickness of contact layer 2 is selected so as to provide the required variation in the reflectivity of the first mirror means 3, wherein the optical characteristics of the grid layer 4 having openings 6 are taken into account. In this embodiment, optical confinement of the radiation is achieved by firstly forming a mesa containing the first mirror means 3 and, secondly, by a resistance layer 11 formed by selective oxidation of the peripheral portion of a layer of high Al content during the formation of the mesa, thereby providing an electrically insulating portion in resistance layer 11.

In operation, an electric current is supplied to the active region 1 via grid layer 4 which is comprised of a stack of layers formed of Pt, Ti, Pt and Au, with respective thicknesses of 10nm, 10nm, 10nm and 70nm, and metal layer 9, so as to create a population inversion in the p-n junction of the active region 1. The composition of the grid layer 4 and the thickness of contact layer 2 is selected so as to obtain a high reflectivity below the openings 6 of the grid layer 4, which serve as radiation emission windows for the stimulated radiation. Below the regions which are covered by the grid layer 4, the reflectivity is remarkably reduced and, hence, the losses in these regions are increased so that the transverse radiation mode having an intensity maximum under the openings 6 is stabilized. A curve 8 in Figure 1 schematically depicts an intensity variation of the corresponding transverse radiation mode.

In Figure 2, there is shown a graph which illustrates the reflectivity of the combination of first mirror means 3, contact layer 2 and grid layer 4. In Figure 2, the relative reflectivity of mirror means 3 is plotted versus the thickness of contact layer 2 which is, in this example, formed of GaAs. The solid line in Figure 2 refers to the reflectivity below the openings 6 of the grid layer 4, wherein an interface from contact layer 2 to air contributes to the overall reflectivity. As can be seen from this curve, the maximum reflectivity is about 99.4% at an appropriate thickness of 190nm. The minimum reflectivity is obtained at about 137nm and amounts to about 95.7%. The dashed line in Figure 2 represents the reflectivity under the portions which are covered by the grid layer 4 which is composed of Pt, Ti, Pt, and Au. As can be seen from this curve, the minimum reflectivity is located at a thickness of 181 nm and amounts to about 96%. As indicated in Figure 2, a respective difference between the two reflectivities for a selected thickness of contact layer 2 can be determined. In this example, a difference of 3.5% is obtained at a thickness where the reflectivity below the grid layer 4 is minimized. Moreover, in Figure 2, the vertical dotted line at about 203.7nm represents the ¾ wavelength thickness of a corresponding cap layer which may be employed in conventional VCSEL devices. As shown in this Figure, the difference in the corresponding reflectivities is 0.7% and is, thus, significantly lower than that of the device according to the present invention. The results in Figure 2 are determined by a calculation performed for a VCSEL structure for an output wavelength of 960nm. The simulated top distributed Bragg reflector in the example consists of 21 pairs of alternating $\lambda/4$ layers of GaAs (67.9nm) and $Al_{0.9}Ga_{0.1}As$ (79.8nm).

The thickness of the topmost GaAs layer (contact layer) was varied in the calculation, so as to find the final layer thickness where the reflectivity below the grid layer is most effectively suppressed. The reflectivity suppression is due to the phase mismatch of the reflective waves from the distributed Bragg reflector and the interface between the contact layer and the grid layer. In the calculation, the thicknesses of Pt, Ti, Pt, and Au are 10nm, 10nm, 10nm, and 70nm, respectively.

It should be noted that in Figure 2, a thickness of contact layer 2 was selected which provides the maximum difference of the reflectivities. It may, however, be sufficient that the thickness of contact layer 2 is selected within a certain range around the minimum reflectivity in order to obtain the required reflectivity contrast. For many applications, a thickness of contact layer 2 within $\pm20$nm of the minimum may be appropriate. Furthermore, in this example, the calculations have been performed with the above-mentioned parameters, however, other parameters as well as other materials may be selected in accordance with design requirements.

The lateral patterning of the top mirror allows to select a single transverse supermode by increasing the cavity losses of the other modes. This can be seen from the following explanation. In a large area VCSEL, each of the many possible transverse modes must meet a modal threshold condition:

$$\Gamma g_{th}^{lm} = \alpha + \frac{1}{L}\ln\left(\frac{1}{R^{lm}}\right)$$

where $\Gamma$ is a confinement factor of the radiation field (overlap of the radiation field with the gain region), $g_{th}^{lm}$ is the threshold gain of mode $lm$, $\alpha$ a wavelength-de-

pendent loss factor, $L$ the cavity length, and $R$ the product of bottom mirror reflectivity times top mirror reflectivity for mode $lm$ ($l, m$ are mode indices). If, for all modes, $\Gamma$, $l$ and $\alpha$ do not change, then the threshold gain of each mode is directly related to the modal reflectivity $R$. If no contact layer and grid layer in accordance with the present invention are provided, all modal reflectivities are the same, and strong mode competition (multimode emission) is observed. If at least one of the mirrors has a laterally varying reflectivity, the modal reflectivity can be calculated with the following equation:

$$R^{lm} = \int I^{lm}(x,y) \cdot R(x,y)\,dxdy,$$

where $I^{lm}(x,y)$ is the normalized radiation field intensity of mode $lm$ at position (x,y). With a mirror having a laterally varying reflectivity, this overlap integral differs substantially for different lateral modes. In particular, if $R(x,y)$ is largely reduced at the regions covered by the grid, for example, a square grid, every mode except the mode having intensity minima at locations coinciding with the grid coverage suffers from a depressed modal reflectivity. Accordingly, the mode with intensity minima on the grid is the "phase coupled array mode" or supermode, which lases with a phase shift of 180° with respect to neighboring VCSEL elements.

As a consequence, the usage of a contact layer having the correct thickness allows to largely increase the losses of the undesired modes and, hence, suppresses mode competition and stabilizes the supermode.

In Figures 3a to 3e, various geometric structures of the grid layer 4 are shown. In Figure 3a, a square grid is shown in which a bar width of the grid, indicated as a black line in Figure 3a, is approximately 1µm and the dimension of the grid opening representing the radiation emission window is 4µm. The far field beam of a VCSEL having the above-mentioned square grid comprises 4 beam spots.

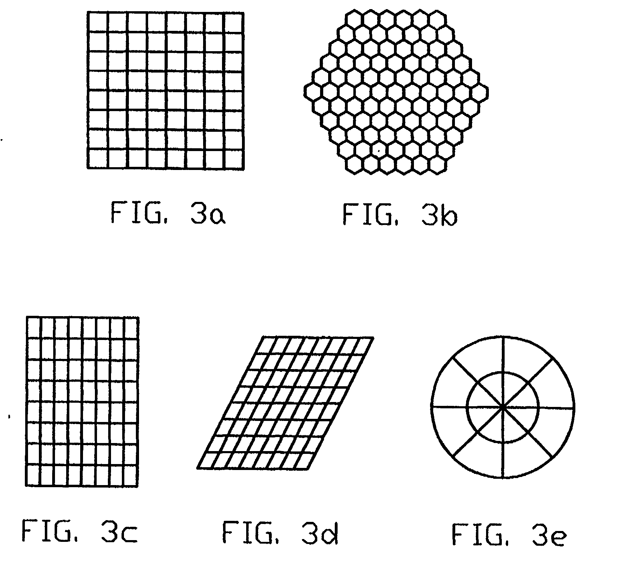

Figure 3b shows a honeycomb structure, wherein the openings are on a triangular lattice. A VCSEL device having this structure exhibits 6 far field beam spots.

Figures 3c and 3d show a rectangular phase coupled array and a rhombic phase coupled array, respectively, wherein the electric fields of adjacent VCSEL elements in the rhombic array are decoupled when the tilt angle exceeds a certain value.

Figure 3e shows an alternative arrangement containing concentric circles with dividing bars, wherein no transverse array mode is stabilized, but a radial symmetric mode in a circular VCSEL is preferred.

With reference to Figures 4a to 4d, a further embodiment of the present invention based on the honeycomb structure as shown in Figure 3d is described.

Figure 4a shows the phase conditions in the honeycomb structure, in which, as previously mentioned, the phase shift between adjacent VCSEL elements is 180°. This is indicated in Figure 4a by a "0" for no phase shift and a "π" for a phase shift of 180°. As can be seen in Figure 4a, however, there are VCSEL elements which are adjacent to both "π"-elements as well as "0"-elements. Accordingly, these elements indicated as white areas in Figure 4a will not lase in a defined phase relationship to their neighboring VCSEL elements, since they do not "know" how to respond to the adjacent electric fields of different phase, i.e both 0° and 180°.

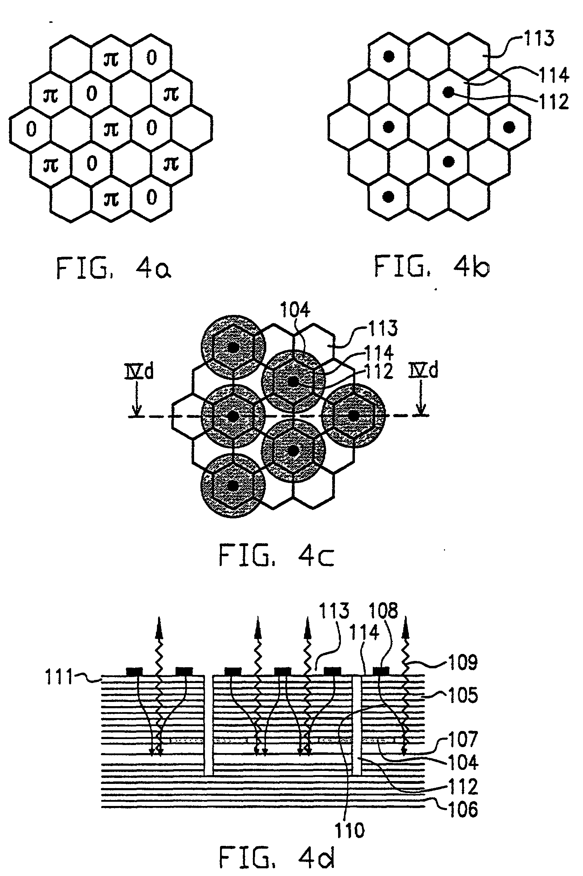

Figure 4b is a schematic top view of the geometric structure as shown in Figure 4a. Here, the VCSEL elements, which are not able to enter the transverse supermode due to the different phases of adjacent VCSEL elements 113 having alternatingly the phase difference of 180°, are indicated by reference numeral 114. In the center of non-lasing VCSEL element 114, a vertical opening 112 is formed by, for example, an appropriate etch process. Preferably, opening 112 extends beyond a certain layer having a high Al content so as to perform a selective oxidation process similar to that carried out when a mesa containing the top mirror is etched. The formation of the openings 112 does not disadvantageously affect the six nearest neighbor VCSEL elements 114.

Figure 4c is a schematic top view of the structure shown in Figure 4b and illustrates the results of the performed etch process and oxidation. Due to the selective oxidation process, the aluminum contained in said specific layer having the high aluminum content is oxidized into $Al_2O_3$ and forms a resistance layer 104 having a relatively high electric resistance. The horizontal extension of resistance layer 104, i.e. the radius of resistance layer 104 in Figure 4c, depends on the initial aluminum contents and the parameters of the etch process and oxidation. Moreover, resistance layer 104 may provide for an additional optical confinement.

Figure 4d is a schematic cross-sectional view taken along the line IVd in Figure 4c. In Figure 4d, an active region 107 is sandwiched between a bottom Bragg reflector 106 and a top Bragg reflector 105. On the top Bragg reflector 105 a contact layer 111 is provided, which, in turn, is partly covered by a grid layer 108. The composition and the thickness of grid layer 108 and the thickness of contact layer 111 are selected so as to yield a minimum reflectivity of the top Bragg reflector 105 in regions below the grid layer 108 as previously discussed. Due to the presence of the resistance layer 104 having a high electric resistance, a flow of charge carriers 110 is deflected so as to yield an enlarged current through the portions of the active region 107 which belong to the lasing VCSEL elements 114. This results in an increased optical gain, an improved efficiency of the VCSEL device and a significantly reduced heat development in the active region 107.

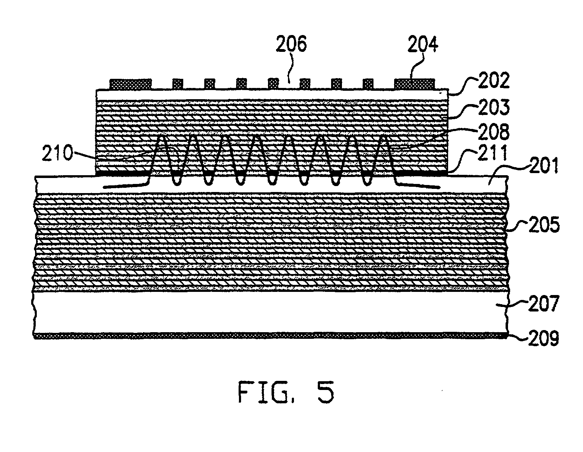

With reference to Figure 5, a further preferred embodiment is now described. Figure 5 is a schematic cross-sectional view of a VCSEL device similar to that shown in Figure 1, and like parts in the VCSEL device are indicated by like reference numerals but increased by 200. The description and explanation of these parts is omitted. Differences between the two embodiments reside in the fact that the embodiment of Figure 5 comprises a grid matching resistance layer 211 having additional resistance areas 210. The resistance areas 210 are arranged so as to coincide with the structure of a grid layer 204. The grid matching resistance layer 211 may be formed by selective oxidation or by any other suitable deposition and patterning process known in the art. Since the resistance areas 210 exhibit a high electrical resistance, the current flow of the charge carriers through an active region 201 is deflected so as to concentrate in those portions of active region 201 which correspond to grid openings 206. Since a high current density in regions of high reflectivity is desired, the current concentration in these regions considerably improves the gain of the laser device by increasing the conversion efficiency and reducing losses of the device which are effected by current flows through noncontributing portions of the active region 201.

The present invention has been described with reference to preferred embodiments in which a VCSEL device comprises a mesa and emits a laser beam through the top Bragg reflector. The contact layer and the grid layer having the features as previously discussed, however, may be incorporated in any kind of VCSEL device, such as selectively oxidized VCSELs, simple mesa-etched VCSELs, proton-implanted VCSELs, and bottom-emitting VCSELs. Furthermore, the present invention may advantageously be combined with any further feature that enhances the reflectivity of the mirrors. This may, for example, be obtained by depositing Au on the top surface of VCSEL elements in the case of a bottom emitter, or by means of additional dielectric mirror pairs on top of the grid layer for a top emitter.

**Claims**

1. A vertical-cavity surface-emitting laser (VCSEL) device comprising a plurality of VCSEL elements arranged on a common substrate (7;207), each VCSEL element comprising first mirror means (3;105; 203) and second mirror means (5;106;205), each having a predefined reflectivity at a predetermined wavelength, for forming an optical resonator for said wavelength, a laser active region (1;107;201) disposed between said first and said second mirror means, and a grid layer (4;108;204) arranged over said first mirror means (3;105;203), said grid layer (4;108;204) having a plurality of openings (6;113; 206) corresponding to the respective VCSEL elements,
   **characterized in that**

said VCSEL device comprises a contact layer (2; 111;202) having a predetermined thickness, said contact layer (2;111;202) being interposed between each of said first mirror means and said grid layer (4;108;204), wherein an optical thickness of said contact layer (2;111;202) and a reflectivity and an absorption of said grid layer (4;108;204) is selected so as to provide an effective reflectivity of each of said first mirror means depending on said grid layer (4;108;204) and being different for areas covered by the grid and areas corresponding to said grid openings (6;113;206).

2. The VCSEL of claim 1, wherein said first and second mirror means are provided as Bragg reflectors common to all of said VCSEL elements.

3. The VCSEL of claim 1 or 2, wherein said thickness of said contact layer (2;111;202) is adjusted such that the reflectivity of said first mirror means is reduced in regions covered by the grid, compared to regions corresponding to said grid openings (6;113; 206).

4. The VCSEL according to claim 3, wherein the thickness of said contact layer (2;111;202) is adjusted so as to obtain the minimum reflectivity of said regions covered by said grid layer (4;108;204) for a given composition of the first mirror means and said grid layer.

5. The VCSEL according to any of claims 1 or 4, wherein said grid layer (4;108;204) comprises more than one layer, each of said layers consisting of a material having a defined index of refraction, a defined absorption coefficient and a defined thickness.

6. The VCSEL according to any of claims 1 to 5, wherein said regions not covered by said grid layer (4;108;204) form radiation emission windows of respective elements for a radiation of said wavelength.

7. The VCSEL according to claim 6, wherein an extension of each of said radiation emission windows is arranged to select substantially a fundamental transverse radiation mode of said radiation.

8. The VCSEL according to any of claims 1 to 6, wherein the absolute reflectivity of said first and second mirror means in conjunction with said contact layer (2;111;202) is selected so as to obtain the minimum reflectivity required to generate stimulated emission.

9. The VCSEL according to any of claims 1 to 8, wherein said grid layer (4;108;204) comprises at least one metal layer.

10. The VCSEL according to any of claims 1 to 8, wherein said grid layer (4;108;204) comprises a doped dielectric layer.

11. The VCSEL according to any of claims 1 to 10, wherein an additional dielectric mirror is provided on top of said first mirror means or said grid layer.

12. The VCSEL of any of claims 2 to 11, wherein said reflectivity is reduced by at least 3% compared to the reflectivity of said regions corresponding to said grid openings (6;113;206).

13. The VCSEL of any of claims 1 to 12, wherein said grid layer (4;108;204) is a raster of squares or rectangles.

14. The VCSEL of any of claims 1 to 12, wherein said grid layer (4;108;204) is a rhombic raster.

15. The VCSEL of any of claims 1 to 12, wherein said grid layer (4;108;204) is a honeycomb raster.

16. The VCSEL of any of claims 1 to 15, wherein a bar width of said grid layer (4;108;204) is less than 10 μm, preferably less than 5 μm.

17. The VCSEL of any of claims 1 to 16, wherein a maximum horizontal dimension of each radiation emission window of said VCSEL element is in the range of 2 μm to 10 μm.

18. The VCSEL of claim 15, wherein a resistance layer (104) is provided in which at least one region corresponding to an opening of said honeycomb raster has a high electrical resistance and said at least one high resistance region has six nearest-neighbor-regions having a low electrical resistance.

19. The VCSEL of claim 18, wherein said high resistance region comprises an exposed portion where at least the overlying layers of said active region (1; 107;201) and of the Bragg mirror have a vertical opening (112).

20. The VCSEL of any of claims 1 to 16, wherein a grid matching resistance layer (211) is provided between said first mirror means and said laser active region, said grid matching resistance layer having a high electrical resistance at least in regions corresponding to regions covered by said grid layer.

**Patentansprüche**

1. Vertikalkavität-Oberflächenemissionslaser- (VCSEL) Vorrichtung mit mehreren VCSEL-Elementen, die auf einem gemeinsamen Substrat angeordnet sind (7; 207), wobei jedes VCSEL-Element eine erste Spiegeleinrichtung (3; 105; 203) und eine zweite Spiegeleinrichtung (5; 106; 205) mit jeweils einer vordefinierten Reflektivität bei einer vorbestimmten Wellenlänge aufweist, um einen optischen Resonator für die Wellenlänge zu bilden, einem Laser-aktiven Gebiet (1; 107; 201), das zwischen der ersten und der zweiten Spiegeleinrichtung angeordnet ist, und einer Gitterschicht (4; 108; 204), die über der ersten Spiegeleinrichtung (3; 105; 203) angeordnet ist, wobei die Gitterschicht (4; 108; 204) mehrere Öffnungen (6; 113; 206) entsprechend zu den jeweiligen VCSEL-Elementen aufweist,
**dadurch gekennzeichnet, dass**
die VCSEL-Vorrichtung eine Kontaktschicht (2; 111; 202) mit einer vorbestimmten Dicke aufweist, wobei die Kontaktschicht (2; 111; 202) zwischen jeder der ersten Spiegeleinrichtungen und der Gitterschicht (4; 108; 204) angeordnet ist, wobei eine optische Dicke der Kontaktschicht (2; 111; 202) und eine Reflektivität und eine Absorption der Gitterschicht (4; 108; 204) so gewählt ist, dass eine effektive Reflektivität jeder der ersten Spiegeleinrichtungen in Abhängigkeit der Gitterschicht (4; 108; 204) bereit gestellt wird, die unterschiedlich ist für Bereiche, die von dem Gitter bedeckt sind und für Bereiche, die den Gitteröffnungen (6; 113; 206) entsprechen.

2.   Die VCSEL-Vorrichtung nach Anspruch 1, wobei die ersten und zweiten Spiegeleinrichtungen als Bragg-Reflektoren gemeinsam für alle VCSEL-Elemente vorgesehen sind.

3.   Die VCSEL-Vorrichtung nach Anspruch 1 oder 2, wobei die Dicke der Kontaktschicht (2; 111; 202) so eingestellt ist, dass die Reflektivität der ersten Spiegeleinrichtung in Gebieten, die von dem Gitter bedeckt sind, im Vergleich zu Gebieten, die den Gitteröffnungen (6; 113; 206) entsprechen, reduziert ist.

4.   Die VCSEL-Vorrichtung nach Anspruch 3, wobei die Dicke der Kontaktschicht (2; 111; 202) so eingestellt ist, dass sich eine minimale Reflektivität der von der Gitterschicht (4; 108; 204) bedeckten Gebiete für eine gegebene Zusammensetzung der ersten Spiegeleinrichtung und der Gitterschicht ergibt.

5.   Die VCSEL-Vorrichtung nach einem der Ansprüche 1 bis 4, wobei die Gitterschicht (4; 108; 204) mehr als eine Schicht umfasst, wobei jede der Schichten aus einem Material mit einem definierten Brechungsindex, einem definierten Absorptionskoeffizienten und einer definierten Dicke besteht.

6.   Die VCSEL-Vorrichtung nach einem der Ansprüche 1 bis 5, wobei die nicht von der Gitterschicht (4; 108; 204) bedeckten Gebiete ein Strahlungsemissionsfenster von entsprechenden Elementen für eine Strahlung mit der Wellenlänge bilden.

7.   Die VCSEL-Vorrichtung nach Anspruch 6, wobei eine Abmessung jedes der Strahlungsemissionsfenster so bemessen ist, um im wesentlichen eine fundamentale Strahlungsmode der Strahlung auszuwählen.

8.   Die VCSEL-Vorrichtung nach einem der Ansprüche 1 bis 6, wobei die absolute Reflektivität der ersten und zweiten Spiegeleinrichtungen in Verbindung mit der Kontaktschicht (2; 111; 202) so gewählt ist, dass eine zur Erzeugung stimulierter Strahlung erforderliche minimale Reflektivität erreicht wird.

9.   Die VCSEL-Vorrichtung nach einem der Ansprüche 1 bis 8, wobei die Gitterschicht (4; 108; 204) mindestens eine Metallschicht aufweist.

10.   Die VCSEL-Vorrichtung nach einem der Ansprüche 1 bis 8, wobei die Gitterschicht (4; 108; 204) eine dotierte dielektrische Schicht aufweist.

11.   Die VCSEL-Vorrichtung nach einem der Ansprüche 1 bis 10, wobei ein zusätzlicher dielektrischer Spiegel auf der ersten Spiegeleinrichtung oder der Gitterschicht vorgesehen ist.

12.   Die VCSEL-Vorrichtung nach einem der Ansprüche 2 bis 11, wobei die Reflektivität um mindestens 3% im Vergleich zu der Reflektivität der den Gitteröffnungen (6; 113; 206) entsprechenden Gebieten reduziert ist.

13.   Die VCSEL-Vorrichtung nach einem der Ansprüche 1 bis 12, wobei die Gitterschicht (4; 108; 204) ein Raster aus Quadraten oder Rechtecken ist.

14.   Die VCSEL-Vorrichtung nach einem der Ansprüche 1 bis 12, wobei die Gitterschicht (4; 108; 204) ein rhombisches Raster ist.

15.   Die VCSEL-Vorrichtung nach einem der Ansprüche 1 bis 12, wobei die Gitterschicht (4; 108; 204) ein wabenförmiges Raster ist.

16.   Die VCSEL-Vorrichtung nach einem der Ansprüche 1 bis 15, wobei eine Balkenbreite der Gitterschicht (4; 108; 204) kleiner als 10 μm und vorzugsweise kleiner als 5 μm ist.

17.   Die VCSEL-Vorrichtung nach einem der Ansprüche 1 bis 16, wobei eine maximale horizontale Abmessung jedes Strahlungsemissionsfensters der VCSEL-Elemente im Bereich von 2µm bis 10µm liegt.

**18.** Die VCSEL-Vorrichtung nach Anspruch 15, wobei eine Widerstandsschicht (104) vorgesehen ist, in der mindestens ein Gebiet, das einer Öffnung in dem wabenförmigen Raster entspricht, einen hohen elektrischen Widerstand aufweist, und wobei ein Gebiet mit hohem Widerstand sechs nächste Nachbargebiete mit einem geringen elektrischen Widerstand besitzt.

**19.** Die VCSEL-Vorrichtung nach Anspruch 18, wobei das Gebiet mit hohem Widerstand eine freigelegten Bereich aufweist, in dem zumindest die darüber liegenden Schichten des aktiven Gebiets (1; 107; 201) und des Bragg-Reflektors eine vertikale Öffnung (112) aufweisen.

**20.** Die VCSEL-Vorrichtung nach einem der Ansprüche 1 bis 16, wobei eine Gitter-angepasste Widerstandsschicht (211) zwischen der ersten Spiegeleinrichtung und dem Laser-aktiven Gebiet vorgesehen ist, wobei die Gitter-angepasste Widerstandsschicht einen hohen elektrischen Widerstand zumindest in Gebieten, die den von der Gitterschicht bedeckten Gebieten entsprechen, aufweist.

**Revendications**

**1.** Dispositif de laser à cavité verticale à émission par la surface (VCSEL) comprenant une pluralité d'éléments VCSEL disposés sur un substrat commun (7 ; 207), chaque élément VCSEL comprenant un premier moyen de miroir (3 ; 105 ; 203) et un second moyen de miroir (5 ; 106 ; 205), ayant chacun un coefficient de réflexion prédéfini à une longueur d'onde prédéterminée, pour former un résonateur optique à ladite longueur d'onde, une région active de laser (1 ; 107 ; 201) disposée entre lesdits premier et second moyens de miroir, et une couche de grille (4 ; 108 ; 204) disposée par dessus ledit premier moyen de miroir (3 ; 105 ; 203), ladite couche de grille (4 ; 106 ; 204) ayant une pluralité d'ouvertures (6 ; 113 ; 206) correspondant aux éléments VCSEL respectifs, **caractérisé en ce que** ledit dispositif de VCSEL comprend une couche de contact (2 ; 111 ; 202) ayant une épaisseur prédéterminée, ladite couche de contact (2 ; 111 ; 202) étant interposée entre chacun desdits premiers moyens de miroir et ladite couche de grille (4 ; 108 ; 204), dans lequel une épaisseur optique de ladite couche de contact (2 ; 111 ; 202), un coefficient de réflexion et un coefficient d'absorption de ladite couche de grille (4 ; 108 ; 204) sont sélectionnés pour fournir un coefficient de réflexion effectif de chacun desdits premiers moyens de miroir en fonction de ladite couche de grille (4 ; 108 ; 204) en étant différents pour les zones recouvertes par la grille et les zones correspondant auxdites ouvertures de grille (6 ; 113 ; 206).

**2.** VCSEL selon la revendication 1, dans lequel lesdits premiers et seconds moyens de miroir sont prévus sous forme de réflecteurs de Bragg, communs à la totalité desdits éléments VCSEL.

**3.** VCSEL selon l'une des revendications 1 ou 2, dans lequel ladite épaisseur de ladite couche de contact (2 ; 111 ; 202) est ajustée de manière à ce que le coefficient de réflexion dudit premier moyen de miroir soit réduit dans les régions recouvertes par la grille comparativement aux régions correspondant auxdites ouvertures de grille (6 ; 113 ; 206).

**4.** VCSEL selon la revendication 3, dans lequel l'épaisseur de ladite couche de contact (2 ; 111 ; 202) est ajustée de manière à obtenir le coefficient de réflexion minimal desdites régions recouvertes par ladite couche de grille (4 ; 108 ; 204) pour une composition donnée du premier moyen de miroir et de ladite couche de grille.

**5.** VCSEL selon l'une quelconque des revendications 1 ou 4, dans lequel ladite couche de grille (4 ; 108; 204) comprend plus d'une couche, chacune desdites couches consistant en un matériau ayant un indice de réfraction défini, un coefficient d'absorption défini et une épaisseur définie.

**6.** VCSEL selon l'une quelconque des revendications 1 à 5, dans lequel lesdites régions qui ne sont pas recouvertes par ladite couche de grille (4 ; 108 ; 204) forment des fenêtres d'émission de rayonnement des éléments respectifs pour un rayonnement à ladite longueur d'onde.

**7.** VCSEL selon la revendication 6, dans lequel un prolongement de chacune desdites fenêtres d'émission du rayonnement est disposé pour sélectionner substantiellement un mode de rayonnement transverse fondamental dudit rayonnement.

**8.** VCSEL selon l'une quelconque des revendications 1 à 6, dans lequel le coefficient de réflexion absolu desdits premiers et seconds moyens de miroir en liaison avec ladite couche de contact (2 ; 111 ; 202) est sélectionné de manière à obtenir le coefficient de réflexion minimal pour générer une émission stimulée.

**9.** VCSEL selon l'une quelconque des revendications 1 à 8, dans lequel ladite couche de grille (4 ; 108 ; 204) comprend au moins une couche de métal.

**10.** VCSEL selon l'une quelconque des revendications 1 à 8, dans lequel ladite couche de grille (4 ; 108 ; 204) comprend une couche diélectrique dopée.

**11.** VCSEL selon l'une quelconque des revendications 1 à 10, dans lequel un miroir diélectrique supplémentaire est prévu sur le dessus dudit premier moyen de miroir ou de ladite couche de grille.

**12.** VCSEL selon l'une quelconque des revendications 2 à 11, dans lequel ledit coefficient de réflexion est réduit d'au moins 3% par rapport au coefficient de réflexion desdites régions correspondant auxdites ouvertures de la grille (6 ; 112 ; 206).

**13.** VCSEL selon l'une quelconque des revendications 1 à 12, dans lequel ladite couche de grille (4 ; 108 ; 204) est un treillis de carrés ou de rectangles.

**14.** VCSEL selon l'une quelconque des revendications 1 à 12, dans lequel ladite couche de grille (4 ; 108 ; 204) est un treillis rhombique.

**15.** VCSEL selon l'une quelconque des revendications 1 à 12, dans lequel ladite couche de grille (4 ; 108 ; 204) est un treillis en nids d'abeille.

**16.** VCSEL selon l'une quelconque des revendications 1 à 15, dans lequel la largeur de barreau de ladite couche de grille (4 ; 108 ; 204) est inférieure à 10 μm, de préférence inférieure à 5 μm.

**17.** VCSEL selon l'une quelconque des revendications 1 à 16, dans lequel une dimension horizontale maximale de chaque fenêtre d'émission du rayonnement dudit élément VCSEL se situe dans la plage allant de 2 μm à 10 μm.

**18.** VCSEL selon la revendication 15, dans lequel est prévue une couche de résistance (104) dont au moins une région correspondant à une ouverture dudit treillis en nids d'abeille a une résistance électrique élevée et ladite au moins une région à résistance élevée a six plus proches régions voisines ayant une faible résistance électrique.

**19.** VCSEL selon la revendication 18, dans lequel ladite région à résistance élevée comprend une portion exposée où au moins les couches de recouvrement de ladite région active (1 ; 107 ; 201) et du miroir de Bragg ont une ouverture verticale (112).

**20.** VCSEL selon l'une quelconque des revendications 1 à 16, dans lequel une couche (211) à résistance d'adaptation de grille est prévue entre ledit premier moyen de miroir et ladite région active de laser, ladite couche à résistance d'adaptation de grille ayant une résistance électrique élevée au moins dans les régions correspondant aux régions recouvertes par ladite couche de grille.

FIG. 1

FIG. 2

FIG. 3b

FIG. 3a

FIG. 3e

FIG. 3d

FIG. 3c

FIG. 4a

FIG. 4b

FIG. 4c

FIG. 4d

206    204

202
203
208
210    211    201

FIG. 5

205

207
209